Europäisches Patentamt

European Patent Office

Office européen des brevets

(11) Publication number: **0 225 489**
**A2**

(12) **EUROPEAN PATENT APPLICATION**

(21) Application number: 86115474.8

(22) Date of filing: 07.11.86

(51) Int. Cl.4: **H03K 19/094**

(30) Priority: 13.11.85 JP 255256/85

(43) Date of publication of application:
**16.06.87 Bulletin 87/25**

(84) Designated Contracting States:
**DE FR GB**

(71) Applicant: **NEC CORPORATION**
**33-1, Shiba 5-chome, Minato-ku**
**Tokyo 108(JP)**

(72) Inventor: **Yamada, Kazuyoshi c/o NEC**
**Corporation**
**33-1, Shiba 5-chome**
**Minato-ku Tokyo(JP)**

(74) Representative: **Glawe, Delfs, Moll & Partner**
**Patentanwälte**
**Postfach 26 01 62 Liebherrstrasse 20**
**D-8000 München 26(DE)**

(54) **Logic circuit.**

(57) For achieving high switching speed and high noise immunity, there is disclosed a logic circuit comprising a logic gate having at least one CMOS inverter circuit provided between voltage sources of high and low levels and having a first intermediate node, the logic gate being responsive to at least one input signal applied thereto and operative to carry out the logical operation for changing a voltage level at the first intermediate node between the high and low levels, a series combination of first and second bipolar transistors provided between the voltage sources and having an output node provided between the first and second bipolar transistors, the first and second bipolar transistors being complementarily changed between on and off conditions based on voltage levels of respective base nodes thereof for changing a voltage level at the output node between the high and low levels, a series combination of gate means and a resistor provided between the output node and one of the voltage sources and having a second intermediate node provided between the gate means and the resistor, the gate means being responsive to the input signal and operative to establish or block an electrical path between the output node and one of the voltage sources for supplying said second intermediate node with the opposite voltage level to the voltage level at the first intermediate node, a first voltage level propagation path operative to apply the voltage level appearing at the first intermediate node to the base node of the first bipolar transistor, and a second voltage level propagation path operative to apply the voltage level appearing at the second intermediate node to the base node of the second bipolar transistor.

FIG. 2

## " LOGIC CIRCUIT "

### FIELD OF THE INVENTION

This invention relates to a logic circuit and, more particularly, to a logic circuit constituted by CMOS inverter circuits and bipolar transistors.

### BACKGROUND OF THE INVENTION

CMOS technology has been intensively investigated for application in VLSI system because of its low power consumption and high noise immunity. However, the limited driving capability of CMOS circuits degrades performance in VLSI systems where signals frequently drive large parasitic capacitances. On the other hand, bipolar circuits can drive capacitive loads with much less speed degradation, however the large-scale integration of high-performance bipolar circuits is limited by power dissipation. In order to achieve low power consumption and large driving capability, the two technologies were combined to form Bi-CMOS circuits on a single semiconductor substrate. Some Bi-CMOS circuits are disclosed by Shi-Chuan Lee et al. in " Bi-CMOS Technology for High-Performance VLSI Circuit ", VLSI DESIGN August 1984, pp 98 to 100.

However, problems have been encountered in the disclosed Bi-CMOS circuits in limited switching speed and low noise immunity.

It is therefore an important object of the present invention to provide a Bi-CMOS circuit which has an improved switching speed and high noise immunity.

### SUMMARY OF THE INVENTION

In accordance with the present invention, there is provided a logic circuit for a logical operation comprising a) a logic gate having at least one CMOS inverter circuit provided between voltage sources of high and low levels and having a first intermediate node, the logic gate being responsive to at least one input signal applied thereto and operative to carry out the logical operation for changing a voltage level at the first intermediate node between the high and low levels, b) a series combination of first and second bipolar transistors provided between the voltage sources and having an output node provided between the first and second bipolar transistors, the first and second bipolar transistors being complementarily changed between on and off conditions based on voltage levels of respective base nodes thereof for changing a voltage level at the output node between the high and low levels, c) a series combination of gate means and a resistor provided between the output node and one of the voltage sources and having a second intermediate node provided between the gate means and the resistor, the gate means being responsive to the input signal and operative to establish or block an electrical path between the output node and one of the voltage sources for supplying the second intermediate node with the opposite voltage level to the voltage level at the first intermediate node, d) a first voltage level propagation path operative to apply the voltage level appearing at the first intermediate node to the base node of the first bipolar transistor, and e) a second voltage level propagation path operative to apply the voltage level appearing at the second intermediate node to the base node of the second bipolar transistor.

### BRIEF DESCRIPTION OF THE DRAWINGS

The problems of a prior-art Bi-CMOS circuit and the features and advantages of a logic circuit according to the present invention will be more clearly understood from the following description taken in conjunction with the accompanying drawings in which:

Fig. 1 is a circuit diagram showing the arrangement of a representative example of a prior-art Bi-CMOS circuit;

Fig. 2 is a circuit diagram showing the circuit arrangement of a first preferred embodiment of a logic circuit according to the present invention;

Fig. 3 is a circuit diagram showing the circuit arrangement of a second preferred embodiment according to the present invention; and

Fig. 4 is a circuit diagram showing the circuit arrangement of a third embodiment according to the present invention.

### DESCRIPTION OF THE PRIOR-ART

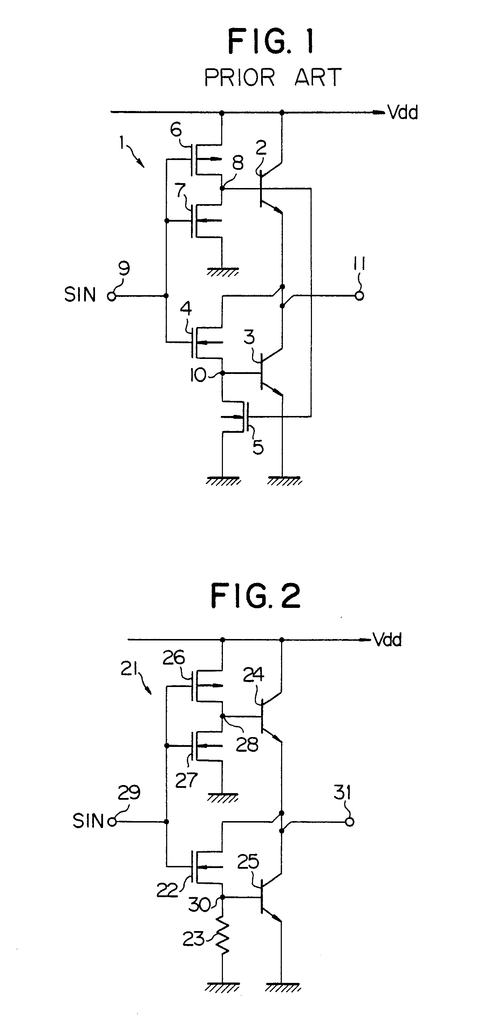

In Fig. 1 of the drawings, there is shown a known Bi-CMOS circuit which basically comprises a CMOS inverter circuit 1, a series combination of NPN bipolar transistors 2 and 3, and a series combination of two n-channel MOS transistors 4 and 5. The CMOS inverter circuit 1 is provided between a positive voltage source Vdd and the ground and consists of a p-channel MOS transistor 6 and an n-channel MOS transistor 7 electrically connected in series through a common drain node 8. The MOS transistors 6 and 7 have respective gate electrodes electrically connected to an input node 9 where an input signal SIN changing its voltage level between high and low levels is applied. The CMOS inverter circuit 1 thus arranged is operative to swing the voltage level at the common drain node 8 based on the complementary on and off conditions of the MOS transistors 6 and 7, thereby producing the inverse of the input signal SIN.

The series combination of the n-channel MOS transistors 4 and 5 has a common drain node 10 intervening therebetween. The n-channel MOS transistor 4 has a gate electrode electrically connected to the input node 9, and the n-channel MOS transistor 5 has a gate electrode electrically connected to the common drain node 8 of the CMOS inverter circuit 1. The inverse of the input signal SIN appears at the common drain node 8, so that the two n-channel MOS transistors 4 and 5 are complementarily changed between the on and off conditions. For this reason, the common drain node 10 has a voltage level changing in the opposite direction to that of the common drain node 8.

The series combination of the NPN bipolar transistors 2 and 3 is provided between the positive voltage source Vdd and the ground and has an output node 11 intervening between the NPN bipolar transistors 2 and 3. The output node 11 is electrically communicable with the common drain node 10 through the n-channel transistor 4, so that the the NPN bipolar transistor 3 is operative to be a diode changed between on and off conditions. The NPN bipolar transistor 2 and the NPN bipolar transistor 3, or the diode, have respective base electrodes electrically connected to the common drain nodes 8 and 10, respectively, and are complementarily changed between the on and off conditions depending upon the voltage levels at the common drain nodes 8 and 10.

Operations of the prior-art Bi-CMOS circuit thus arranged are described hereinunder. When the input node 9 goes down from the high level to the low level, the common drain node 8 has the high level by turning the p-channel MOS transistor 6 on and the n-channel MOS transistor 7 off. On the other hand, the common drain node 10 has the low level by turning the n-channel MOS transistor 4 off and the n-channel MOS transistor 5 on due to the input signal SIN and the inverse thereof. These voltage levels at the common drain nodes 8 and 10 result in complementary on and off conditions of the NPN bipolar transistors 2 and 3. Namely, the common drain node 8 with a sufficient forward-biased voltage level turns the NPN bipolar transistor 2 on , and the NPN transistor 3, or the diode formed therein, is changed into the off condition, thereby causing the output node 11 to have the high voltage level corresponding to the common drain node 8.

On the contrary, when the input signal SIN goes up to the high level, the CMOS inverter circuit 1 changes the common drain node 8 into the low level by turning the p-channel transistor 6 off and the n-channel transistor 7 on. The input node 9 with the input signal SIN turns the n-channel MOS transistor 4 on at the same time, however the n-channel transistor 5 remains in the on condition for a while. The voltage level at the common drain node 8 decreases with time, so that the n-channel MOS transistor 5 is finally changed into the off condition when the voltage level goes down across the threshold voltage thereof. However, prior to reaching the threshold voltages of the n-channel MOS transistor 5, a current path takes place between the output node 11 and the ground through the n-channel MOS transistors 4 and 5 in the simultaneous on conditions, and this current path prevents the common drain node 10 from having a sufficient forward-biased voltage level for the diode formed in the NPN bipolar transistor 3. This means that the diode formed in the NPN bipolar transistor 3 remains in off condition for a while, thereby preventing the prior-art Bi-CMOS circuit from high speed operations. In other words, the output node 11 is not actually in the signal path until the common drain node 10 with the sufficient forward-biased voltage level turns the diode in the NPN bipolar transistor 3 on.

Another problem encountered in the prior-art Bi-CMOS circuit illustrated in Fig. 1 is low noise immunity. When the input signal SIN goes up to the high level, the n-channel MOS transistor 4 is changed in the on condition. The common drain node 10 has the approximately equal voltage level to the output node 11, and the NPN bipolar transistor 3 is operative as a forward-biased diode after a certain period of time as described hereinbefore. The charges in a load ( not shown ) are discharged through the transistors 3 and 4 to lower the voltage level at the output node 11. However, the n-channel MOS transistor 5 has been already changed into the off condition, so that the output node 11 is capable of being grounded only through the diode in the NPN bipolar transistor 3 and the charges in the load are accumulated in the parasitic capacitor of the diode. At this time, since the n-channel MOS transistor is in the off condition, the parasitic capacitor of the diode has no discharging route for the accumulated charges and then the output drain node 11 keeps a certain positive voltage level equal to the threshold voltage of the diode formed in the NPN bipolar transistor 3. As a result, a certain positive voltage level due to the accumulated charges remains on the output node 11 even if the output node 11 is in stable condition. This decreases the noise immunity of the Bi-CMOS circuit.

## DESCRIPTION OF THE PREFERRED EMBODIMENTS

First Embodiment

Referring to Fig. 2 of the drawings, a logic circuit embodying the present invention is shown and basically comprises a CMOS inverter circuit 21, a series combination of an n-channel MOS transistor 22 and a resistor 23, and a series combination of NPN bipolar transistors 24 and 25. The CMOS inverter circuit 21 is provided between a positive voltage source Vdd and the ground and consists of a p-channel MOS transistor 26 and an n-channel transistor 27 electrically connected in series through a common drain node 28. Both of the MOS transistors 26 and 27 have respective gate electrodes electrically connected to an input node 29 where an input signal SIN is applied. The input signal SIN changes its voltage level between high and low levels and is inverted by the CMOS inverter circuit 21 to produce the inverse of the input signal SIN which appears at the common drain node 28. In this instance, the common drain node 28 serves as a first intermediate node.

The n-channel MOS transistor 22 is provided between a second intermediate node 30 and an output node 31 intervening between the NPN bipolar transistors 24 and 25 and has a gate electrode electrically connected to the input node 29. The n-channel MOS transistor 30 thus arranged is changed between the on and off conditions by the input signal SIN and is capable of providing an electrical path between the output node 31 and the ground through the second intermediate node 30 and the resistor 23. The output node 31 and the second intermediate node 30 thus electrically connected have respective voltage levels approximately equal to each other, and, for this reason, the NPN bipolar transistor 25 provides a diode changing its voltage level between the high and low levels. In this instance, the resistor 23 has a resistance value ranging between 2 kilo-ohms and 100 kilo-ohms, typically 20 kilo-ohms.

The series combination of the NPN bipolar transistors 24 and 25 is provided between the positive voltage source Vdd and the ground. The NPN bipolar transistors 24 and 25 have respective base electrodes electrically connected to the common drain node 28 and the second intermediate node 30, respectively, and are complementarily changed between the on and off conditions depending upon the voltage level at the common drain node 28 and the second intermediate node 30. Each of the NPN bipolar transistor 24 and the NPN bipolar transistor 25, or the diode formed therein, is changed from the off condition to the on condition when a sufficient forward-biased voltage is provided between the base and emitter electrodes.

In operation, when the input signal SIN goes down to the low level, the inverse of the input signal SIN appears at the common drain node 28 by the function of the CMOS inverter circuit 21. As a result, the common drain node 28 with the sufficient forward-biased voltage level turns the NPN bipolar transistor 24 on, and the positive voltage source Vdd supplies the output node 31 with a positive voltage level. When the input signal SIN goes down, the n-channel MOS transistor 22 is immediately changed into the off condition, and, for this reason, the second intermediate node 30 rapidly goes down to the ground level. The NPN bipolar transistor 25, or the diode formed therein, is promptly changed into the off condition upon rapid decreasing, so that no current path takes place between the output node 31 and the ground, thereby allowing the output node 31 to have the sufficient high voltage level.

On the other hand, when the input signal SIN goes up to the high level, the inverse of the input signal SIN takes place at the common drain node 28 which causes the NPN bipolar transistor 24 to be changed into the off condition, thereby blocking the electrical path between the positive voltage source and the output node 31. The input node 29 with the high level turns the n-channel transistor 22 on, which provides an electrical path from the output node 31 to the ground through the resistor 23. The positive electric charges flow from the output node 31 to the ground through the resistor 23, thereby pulling the second intermediate node up. This causes the NPN bipolar transistor 25, or the diode formed therein, to be changed into the on condition, so that the output node 31 rapidly goes down toward the low level.

As described hereinbefore, the output node 31 promptly goes up or down in response to the input signal SIN, so that the logic circuit can carry out the logical operation in an improved switching speed.

As to the noise immunity, when the voltage level at the output node 31 decreases with time, the diode formed in the NPN bipolar transistor 25 is charged to a threshold voltage of the diode formed in the NPN bipolar transistor 25, remaining accumulated charges in the parasitic capacitor formed along the base-emitter junction thereof. However, the second intermediate node 30 is electrically connected to the ground through the resistor 23, so that the accumulated charges are discharged to the ground through the resistor 23. As the n-channel MOS transistor 22 remains in the on condition as long as the input node 29 has the high level, the voltage level on the output node 31 also goes down to the ground level by discharging the diode formed in the NPN bipolar transistor 25. Thus, the output node 31 is capable of having the ground level when the input node 29 goes up to the high level, and, for this reason, the logic circuit has an improved noise immunity. In this instance, the CMOS inverter circuit serves as the logic gate, and the n-channel MOS transistor 22 serves as the short circuiting means.

Second Embodiment

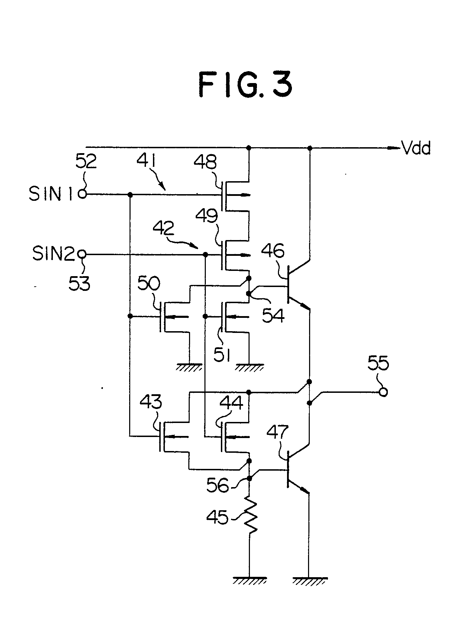

Turning to Fig. 3 of the drawings, there is shown another logic circuit embodying the present invention and basically comprising a logic gate provided with two CMOS circuits 41 and 42, a series combination of gate means having two n-channel MOS transistors 43 and 44 and a resistor 45, and a series combination of NPN bipolar transistors 46 and 47. The two CMOS circuits 41 and 42 have respective p-channel MOS transistors 48 and 49 and respective n-channel MOS transistors 50 and 51. The MOS transistors 48 and 50 forming the CMOS circuit 41 have respective gate electrodes electrically connected to a first input node 52 where a first input signal SIN1 is applied, and the MOS transistors 49 and 51 of the CMOS circuit 42 have respective gate electrodes electrically connected to a second input node 53 where a second input signal SIN2 appears. The MOS transistors 48, 49 and 51 are connected in series between a positive voltage source Vdd and the ground, and the MOS transistor 50 is provided between a first intermediate node 54 intervening between the MOS transistors 49 and 51 and the ground. The logic gate thus arranged carries out a NOR operation based on the first and second input signal SIN1 and SIN2 and puts a low level on the first intermediate node 54 except for simultaneous low levels at the first and second input nodes 52 and 53.

The two n-channel MOS transistors 43 and 44 are arranged in parallel between an output node 55 and a second intermediate node 56 and have respective gate electrodes electrically connected to the first and second input nodes 52 and 53, respectively. The resistor 45 is provided between the second intermediate node 56 and the ground. Either of the n-channel MOS transistors 43 and 44 can provide an electrical path between the output node 55 and the ground except for the simultaneous low levels at the input nodes 52 and 53. In this instance, the n-channel MOS transistors 43 and 44 thus arranged provide gate means, and the resistor 45 has a resistance value ranging between 2 kilo-ohms and 100 kilo-ohms, typically 20 kilo-ohms.

The NPN bipolar transistors 46 and 47 are connected in series through the output node 55 and provided between the positive voltage source Vdd and the ground. The NPN bipolar transistors 46 and 47 have respective base electrodes electrically connected to the first and second intermediate nodes 54 and 56, respectively.

In operation, when then the input signals concurrently go up to the high levels, the low voltage level appears at the first intermediate node 54 by turning the n-channel transistors 50 and 51 on and the p-channel transistors 48 and 49 off. The first intermediate node 54 with low level turns the NPN bipolar transistor 46 off, thereby blocking the electrical path between the positive voltage source Vdd and the output node 55. The input nodes with simultaneous high voltage level further turn the n-channel MOS transistors 43 and 44 on, respectively, and the positive charges flow to the ground through the n-channel MOS transistors 43 and 44 and the resistor 45. This causes the second intermediate node 56 to go up beyond the sufficient forward-biased voltage level for the diode formed in the transistor 47, and, for this reason, the NPN transistor 47, or the diode formed therein, is changed into the on condition. Upon fully open condition of the NPN bipolar transistor 47, the output node 55 rapidly goes down toward the ground level. The n-channel MOS transistors 43 and 44 remain in the on conditions as long as the input nodes 52 and 53 keep the high level, so that the output node 55 can go down to the sufficient low level discharging the parasitic capacitance in the NPN bipolar transistor 47, or in the diode formed therein, through the resistor 45. If one of the input nodes 52 and 53 goes up to the high level, either n-channel MOS transistor 50 or 51 are changed into the on condition, thereby putting the low level on the first intermediate node 54. Either of the n-channel MOS transistors 43 and 44 is changed into on condition so that the output node 55 goes down to the low level as in the case of simultaneous high levels at the input nodes 52 and 53.

On the contrary, when the input nodes 52 and 53 concurrently go down to the low levels, the high voltage level appears at the first intermediate node 54 through the p-channel MOS transistors 48 and 49 which are concurrently changed into the on conditions. However, all of the n-channel MOS transistors 43, 44, 50 and 51 remain in the off conditions. As a result, the output node 55 goes up to the sufficient high level by turning the NPN bipolar transistor 46 on and the NPN bipolar transistor 47 off.

## Third Embodiment

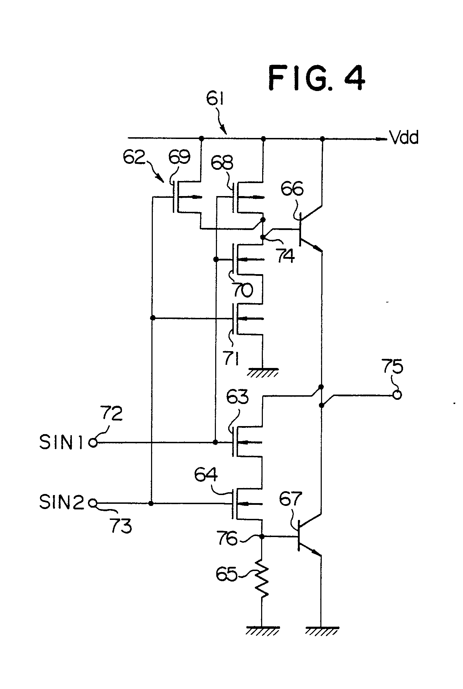

In Fig. 4 is shown still another logic circuit which basically comprises a logic gate provided with two CMOS circuits 61 and 62, a series combination of gate means having two n-channel MOS transistors 63 and 64 and a resistor 65, and a series combination of NPN bipolar transistors 66 and 67. The two CMOS circuits 61 and 62 have respective p-channel MOS transistors 68 and 69 and respective n-channel MOS transistors 70 and 71. The MOS transistors 68 and 70 forming the CMOS circuit 61 have respective gate electrodes electrically connected to a first input node 72 where a first input signal SIN1 is applied, and the MOS transistors 69 and 71 of the CMOS circuit 62 have respective gate electrodes electrically connected to a second input node 73 where a second input signal SIN2 appears. The MOS transistors 68, 70 and 71 are connected in series between a positive voltage source Vdd ahd the ground, and the MOS transistor 69 is provided between the positive voltage source Vdd and a first intermediate node 74 intervening between the MOS transistors 68 and 70. The logic gate thus arranged carries out a NAND operation based on the first and second input signal SIN1 and SIN2 and puts a high level on the first intermediate node 74 except for simultaneous high levels at the first and second input nodes 72 and 73.

The two n-channel MOS transistors 63 and 64 are arranged in series between an output node 75 and a second intermediate node 76 and have respective gate electrodes electrically connected to the first and second input nodes 72 and 73, respectively. The resistor 65 is provided between the second intermediate node 76 and the ground. The series of the n-channel MOS transistors 63 and 64 can provide an electrical path between the output node 75 and the ground only when the input nodes 72 and 73 concurrently go up to the high levels. In this instance, the n-channel MOS transistors 63 and 64 thus arranged provide gate means, and the resistor 65 has a resistance value ranging between 2 kilo-ohms and 100 kilo-ohms, typically 20 kilo-ohms.

The NPN bipolar transistors 66 and 67 are connected in series through the output node 75 and provided between the positive voltage source Vdd and the ground. The NPN bipolar transistors 66 and 67 have respective base electrodes electrically connected to the first and second intermediate nodes 74 and 76, respectively.

In operation, when then the input signals concurrently go up to the high levels, the low voltage level appears at the first intermediate node 74 by turning the n-channel transistors 70 and 71 on and the p-channel transistors 68 and 69 off. The first intermediate node 74 with low level turns the NPN bipolar transistor 66 off, thereby blocking the electrical path between the positive voltage source Vdd and the output node 75. The input nodes 72 and 73 with simultaneous high voltage level further turn the n-channel MOS transistors 63 and 64 on, respectively, and the positive charges flow to the ground through the n-channel MOS transistors 63 and 64 and the resistor 65. This causes the second intermediate node 76 to go up beyond the sufficient forward-biased voltage level for the diode formed in the transistor 67, and, for this reason, the NPN bipolar transistor 67, or the diode, is changed into the on condition. Upon fully open condition of the diode formed in the NPN bipolar transistor 67, the output node 75 rapidly goes down toward the ground level. The n-channel MOS transistors 63 and 64 remain in the on conditions as long as the input nodes 72 and 73 keep the high levels, so that the output node 75 can go down to the sufficient low level discharging the parasitic capacitance of the diode formed in the NPN bipolar transistor 67 through the resistor 65.

On the contrary, when the input nodes 72 and 73 concurrently go down to the low levels, the high voltage level appears at the first intermediate node 74 through the p-channel MOS transistors 68 and 69 which are concurrently changed into the on conditions. However, all of the n-channel MOS transistors 63, 64, 70 and 71 remain in the off conditions. As a result, the output node 55 goes up to the sufficient high level by turning the NPN bipolar transistor 66 on and the diode formed in the NPN bipolar transistor 67 off. If one of the input nodes 72 and 73 goes down to the low level, either of the n-channel MOS transistors 70 and 71 is changed into the off condition. The n-channel MOS transistors 70 and 71 are connected in series, so that the n-channel MOS transistor 70 or 71 in the off condition cuts off the electrical connection between the first intermediate node 74 and the ground. On the other hand, one of the input nodes 72 and 73 with the low level turns either p-channel MOS transistor 68 or 69 on, which supplies the first intermediate node 74 with the positive voltage level, thereby putting the high level on the first intermediate node 54. Although one of the n-channel MOS transistors 63 and 64 is changed into on condition, the output node 75 is not electrically connected to the second intermediate node 76. As the NPN bipolar transistors 66 and 67 are changed into the on and off conditions, respectively, the output node 75 goes up to the high level as in the case of simultaneous low levels at the input nodes 72 and 73.

All of the logic circuit described above have the series combinations of the NPN bipolar transistors, respectively, but it is possible to form a PNP implementation without departing from the spirit and scope of the present invention. Further, a logic circuit with more than two input nodes is also implemented in accordance with the present invention.

As will be understood from the foregoing description, the logic circuit according to the present invention can carry out the logical operation at an improved switching speed, because the bipolar transistors are rapidly shifted between the high and low levels by virtue of the gate means. The logic circuit according to the present invention further achieves a high noise immunity, since the output node is always grounded during the first intermediate node is in the low level.

## Claims

1. A logic circuit for a logical operation comprising,

a) a logic gate having at least one CMOS inverter circuit provided between voltage sources of high and low levels and having a first intermediate node, said logic gate being responsive to at least one input signal applied thereto and operative to carry out said logical operation for changing a voltage level at said first intermediate node between said high and low levels,

b) a series combination of first and second bipolar transistors provided between said voltage sources and having an output node provided between the first and second bipolar transistors, said first and second bipolar transistors being complementarily changed between on and off conditions based on voltage levels of respective base nodes thereof for changing a voltage level at said output node between said high and low levels,

c) a series combination of gate means and a resistor provided between said output node and one of said voltage sources and having a second intermediate node provided between the gate means and the resistor, said gate means being responsive to said input signal and operative to establish or block an electrical path between said output node and one of said voltage sources for supplying said second intermediate node with the opposite voltage level to the voltage level at the first intermediate node,

d) a first voltage level propagation path operative to apply said voltage level appearing at said first intermediate node to the base node of said first bipolar transistor, and

e) a second voltage level propagation path operative to apply said voltage level appearing at said second intermediate node to the base node of said second bipolar transistor.

2. A logic circuit as set forth in claim 1, in which said logic gate comprises a CMOS inverter circuit for inverting a voltage level of an input signal between said high and low levels.

3. A logic circuit as set forth in claim 2, in which said gate means comprises a MOS transistor connected in series to said resistor.

4. A logic circuit as set forth in claim 1, in which said logic gate comprises a plurality of CMOS inverter circuits arranged in such a manner as to carry out a NOR operation based on a plurality of input signals applied thereto.

5. A logic circuit as set forth in claim 4, in which said gate means comprises a plurality of MOS transistors arranged in parallel between said second intermediate node and said control node and having respective gate electrodes supplied with said input signals, respectively.

6. A logic circuit as set forth in claim 1, in which said logic gate comprises a plurality of CMOS inverter circuits arranged in such a manner as to carry out a NAND operation based on a plurality of input signal applied thereto.

7. A logic circuit as set forth in claim 6, in which said gate means comprises a plurality of MOS transistors arranged in series between said output node and said second intermediate node and having respective gate electrodes supplied with said input signals, respectively.

8. A logic circuit as set forth in claim 1, in which said resistor has a resistance value which allows said second intermediate node to have a certain voltage level capable of maintaining said second bipolar transistor in on condition when said gate means establish said electrical path.

9. A logic circuit as set forth in claim 8, in which said resistance value ranges between 2 kilo-ohms and 100 kilo-ohms.

10. A logic circuit as set forth in claim 1, in which said resistance value is about 20 kilo-ohms.

11. A logic circuit for a logical operation comprising,

a) a CMOS inverter circuit having a series combination of a p-channel MOS transistor and an n-channel MOS transistor provided between a positive voltage source and the ground and a first intermediate node provided between the p-channel transistor and the n-channel transistor, said CMOS inverter circuit being responsive to an input signal applied thereto and operative to supply said first intermediate node with a voltage level from said positive voltage source or the ground,

b) a series combination of first and second NPN bipolar transistors provided between said positive voltage source and the ground and having an output node provided between the first and second NPN bipolar transistors, said first and second NPN bipolar transistors being complementarily changed between on and off conditions based on respective base nodes thereof for changing a voltage level at said output node between said high and low levels,

c) a series combination of an n-channel transistor and a resistor provided between said output node and the ground and having a second intermediate node provided between the n-channel transistor and the resistor, said n-channel transistor being responsive to said input signal and operative to establish or block an electrical path between said output node and the ground for supplying said second intermediate node with the opposite voltage level to the voltage level at the first intermediate node,

d) a first voltage level propagation path operative to apply said voltage level appearing at said first intermediate node to the base node of said first NPN bipolar transistor, and

e) a second voltage level propagation path operative to apply said voltage level appearing at said second intermediate node to the base node of said second NPN bipolar transistor.

# FIG. 1
## PRIOR ART

# FIG. 2

# FIG.3

# FIG. 4